# EUROPÄISCHE PATENTSCHRIFT

(11) **EP 1 128 432 B1**
(45) Veröffentlichungstag und Bekanntmachung des Hinweises auf die Patenterteilung: **06.04.2016**
(21) Anmeldenummer: 01103358.6
(22) Anmeldetag: 13.02.2001
(51) Int. Cl.: H01L 23/40

(54) **Befestigung von Halbleitermodulen an einem Kühlkörper**
Fixation of semiconductor modules to a heatsink
Fixation de modules à semi-conducteurs sur un dissipateur de chaleur

(30) Priorität: 24.02.2000 DE 10008571
(43) Veröffentlichungstag der Anmeldung: 29.08.2001
(73) Patentinhaber: Infineon Technologies AG, 85579 Neubiberg (DE)
(72) Erfinder: Hellbrück, Horst, 59581 Warstein (DE); Joerke, Ralf, 59581 Warstein (DE); Kanelis, Konstantin, 81925 München (DE); Loddenkötter, Manfred, 49477 Ibbenbüren (DE); Stolze, Thilo, 59821 Arnsberg (DE)
(74) Vertreter: Müller Hoffmann & Partner

(56) Entgegenhaltungen:
- EP-A- 0 295 387
- WO-A-93/16580
- DE-A- 4 335 299
- DE-U- 9 410 061
- DE-U- 29 817 502
- GB-A- 2 240 425
- US-A- 5 343 362
- US-A- 5 977 622

## Beschreibung

Die Erfindung betrifft die Befestigung von Halbleitermodulen, insbesondere Leistungshalbleitermodulen, z. B. IGBT-Modulen, an einem Kühlkörper. Typischerweise sind Leistungshalbleitermodule derart aufgebaut, dass elektronische Bauteile auf Keramiksubstrate gelötet werden, welche meist (optional) auf eine Bodenplatte gelötet werden, die als Wärmesenke dient. Um ein Leistungshalbleitermodul zu betreiben, muss die in den Bauteilen entstehende Wärme sicher abgeführt werden. Da die optionale Bodenplatte dazu meist nicht ausreicht, wird das Halbleitermodul in der Regel mit der Substrat- bzw. Bodenplattenseite an einen Kühlkörper angeflanscht bzw. mit diesem verschraubt.

Um einen sicheren Wärmeübergang zu gewährleisten, wird bei der Montage meist Wärmeleitpaste oder -folie zwischen die beiden Kontaktflächen, d. h. zwischen den Kühlkörper und das Substrat bzw. die Bodenplatte, gegeben, damit Welligkeiten und Rauhigkeiten ausgeglichen werden. Da die Verbindung bei Erwärmung durch Erhöhung des Setzbetrages durch die verminderte Viskosität der Wärmeleitpaste und/oder -folie an Festigkeit verliert oder bei Phasenwechselmaterialien vom festen in einen weichen (flüssigen) Zustand übergeht, steigt der Übergangswärmewiderstand. Aus diesem Grund ist nach dem Erwärmen ein Nachspannen der Verschraubung oder eine zusätzliche Anordnung von Federringen bei der Verschraubung zu empfehlen.

Aus diesem Grund wird der bei einer Schraubverbindung anfallende Montageaufwand, der bei preiswerten zu fügenden Bauteilen auch ohne den oben beschriebenen Mehraufwand schon die Montagekosten steigert, durch die nach Inbetriebnahme erforderliche Nachspannung erhöhte

Die EP0295387 offenbart eine Vorrichtung mit Halbleitermodul und Kühlkörper, welche mittels einer Federklammer verbunden sind.

Demzufolge liegt dieser Erfindung die Aufgabe zugrunde, eine kostengünstige, einfache und zuverlässige Verbindung zwischen einem Halbleitermodul und einem Kühlkörper herzustellen.

Diese Aufgabe wird erfindungsgemäß durch eine Vorrichtung mit den Merkmalen des unabhängigen Anspruchs 1. Vorteilhafte Weiterbildungen sind jeweils in den jeweils nachgeordneten abhängigen Patentansprüchen angegeben.

Erfindungsgemäß wird das Halbleitermodul mittels einer oder mehrerer Klammern aus Federmaterial, d. h. Federklammern, an den Kühlkörper geklemmt. Der Kühlkörper kann als Strangpressprofil bereits die gewünschte Form aufweisen, die er zur Aufnahme einer Klammer benötigt, ohne dass eine zusätzliche Nachbearbeitung des Kühlkörpers nötig ist. Die Verbindung ist günstiger als eine Verschraubung, da die Montage einfacher und schneller geschehen kann. Weiter kompensiert eine solche Federklammer bei ausreichendem Vorspannweg den Setzbetrag zwischen Kühlkörper und Halbleitermodul, so dass ein sicherer Wärmeübergang ohne Nachspannen oder andere nach dem ersten Betrieb oder während des Betriebs nötige Montageschritte dauerhaft gewährleistet werden kann. Die Klammern sorgen stets für die Einhaltung der gewünschten Spannkraft. Sie weisen eine einfache Form auf und können aus einem elastischen Material bestehen, vorzugsweise Federstahl.

Vorteilhafterweise ist die erfindungsgemäße rationelle Befestigung durch eine aufeinander abgestimmte Form der Klammern und Kühlkörper bzw. Halbleitermodule weiter optimiert. In diesem Fall kann die Verbindung Klammer und Kühlkörper bzw. Halbleitermodul so erfolgen, dass die Klammer eingesetzt oder eingerastet werden kann und auch dann selbsttätig am/im Kühlkörper bzw. Halbleitermodul hält, wenn sie sich nicht im gespannten Zustand befindet, in dem das Halbleitermodul mittels der Federklammer mit dem Kühlkörper verbunden ist.

Nach einem Beispiel weist der Kühlkörper bzw. das Halbleitermodul dazu eine Nut über die gesamte Länge oder zumindest in dem Bereich einer Federklammeraufnahme auf, in dem die Federklammer am Kühlkörper bzw. Halbleitermodul befestigt wird. Alternativ kann der Kühlkörper bzw. das Halbleitermodul an Stelle einer Nut auch einen Kragen aufweisen, über den eine daran angepasste Federklammer eingerastet werden kann.

Die Ausformung der Federklammer erfolgt nach einem weiteren Beispiel weiterhin so, dass das Halbleitermodul bzw. der Kühlkörper ohne zusätzliche seitliche Kräfte allein durch eine in eine Richtung wirkende Montagekraft selbst einrastet. Damit ist auch eine einfache Befestigung von mehreren Halbleitermodulen auf einem Kühlkörper bzw. mehreren Kühlkörpern auf einem Halbleitermodul über die gesamte Länge möglich.

Nach einem anderen Beispiel erhält das Gehäuse des Halbleitermoduls bereits im Gussverfahren wenigstens ein geeignetes Becken zum Einrasten der Federklammer, welches vorzugsweise eine Bordkante aufweist, wodurch die Kosten nicht zusätzlich belastet werden. Eine Federklammer kann dann vorzugsweise automatisch in das Becken eingelegt werden, z. B. bevor die Leiterplatte darüber angelötet wird und das Anordnen der Klammer erschweren würde. Vorzugsweise erhält ein Halbleitermodul wenigstens zwei an gegenüberliegenden Seiten vorgesehene Becken. Weiter können optional auch mehrere Federklammern in ein Becken eingelegt werden oder anstelle einer beckenförmigen Federklammeraufnahme kann eine anders geformte vorgesehen werden, z. B. eine stufenförmige. Nach dem Aufsetzen des Halbleitermoduls auf den Kühlkörper können die geeignet geformten Klammern mit Hilfe eines Werkzeugs, z. B. einer speziell geformten Zange, mit hoher Zuverlässigkeit und Genauigkeit vorzugsweise automatisiert in dafür vorgesehene Nuten im Kühlkörper einrasten. Ist das Halbleitermodul schon mit einem Schaltungsträger verlötet, so kann dieser Einrastvorgang unproblematisch nur von der Seite her ausgeführt werden. Eine auf diese Ausführungsform abgestimmte Federklammer weist vorzugsweise drei Biegekanten auf, um die erste wippt sie beim Einrastvorgang, und um die zweite und dritte entsteht ein Spannbogen. An einer optionalen vierten Biegekante kann das Aufspannen erfolgen.

Die Figuren zeigne:
**Fig. 1** eine Halbleitermodul/Kühlkörper-Befestigung gemäß einem ersten Beispiel.
**Fig. 2** eine Halbleitermodul/Kühlkörper-Befestigung gemäß einem zweiten Beispiel.
**Fig. 3** eine Halbleitermodul/Kühlkörper-Befestigung gemäß einem dritten Beispiel.
**Fig. 4** eine Halbleitermodul/Kühlkörper-Befestigung gemäß einem vierten Beispiel.
**Fig. 5** eine erfindungsgemäße Halbleitermodul/Kühlkörper-Befestigung.
**Fig. 6** eine Federklammer, nach der Erfindung.
**Fig. 7** eine beispielhafte Formgebung des Gehäuses eines halbleitermoduls.

In den nachfolgend beschriebenen bevorzugten Ausführungsformen nach der Erfindung sind gleiche oder ähnliche Elemente mit den gleichen Bezugszeichen versehen.

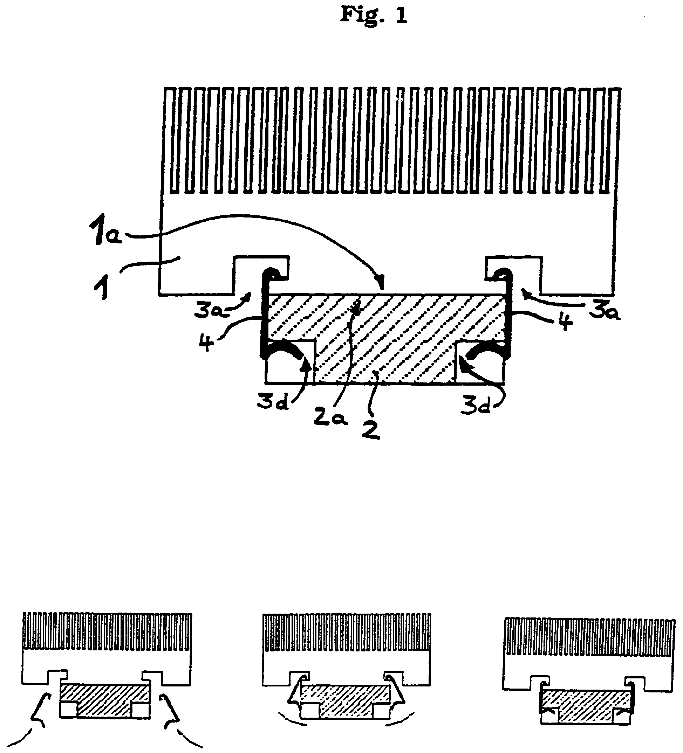

Die Fig. 1 zeigt im oberen Teil einen angepassten Kühlkörper 1 mit einem daran befestigten angepassten Halbleitermodul 2. Das Halbleitermodul 2 liegt mit einer Anlageseite 2a an einer dafür am Kühlkörper 1 vorgesehenen Auflagefläche 1a an diesem an und wird durch zwei Federklammern 4 an den Kühlkörper 1 geklemmt. Im Kühlkörper 1 sind dazu als Federklammeraufnahmen 3a zwei offene Nuten vorgesehen, die aufgrund einer Verbreiterung in den Kühlkörper hinein ein Hintergreifen einer jeweiligen Federklammer 4 in Bezug auf die Andruckrichtung des Halbleitermoduls 2 an den Kühlkörper 1 ermöglichen. Zum Hintergreifen weist eine Federklammer 4 jeweils einen an die jeweilige Federklammeraufnahme 3a angepassten Endbereich auf, der an einer Fläche der Federklammeraufnahme 3a hinterhakt wird, die in einem Bereich der Federklammeraufnahme 3a liegt, welcher die für das Halbleitermodul 2 vorgesehene Auflagefläche 1a des Kühlkörpers 1 teilweise unterhöht. Die jeweilige Federklammer 4 hinterhakt sich in der jeweiligen Federklammeraufnahme 3a in der Art, dass sie in einer Zugrichtung senkrecht auf der Auflagefläche 1a des Kühlkörpers 1 festgehalten wird.

Das Halbleitermodul 2 weist eine jeweilige zweite Federklammeraufnahme 3d auf, an der die jeweilige andere Seite einer Federklammer 4 derart eingreift, dass das Halbleitermodul 2 an der Auflagefläche 1a des Kühlkörpers 1 gehalten und an diese gedrückt wird. Vorteilhafterweise besteht die zweite Federklammeraufnahme 3d aus einem an der der Anlageseite 2a des Halbleitermoduls 2 am Kühlkörper 1 gegenüberliegenden Seite des Halbleitermoduls 2 vorgesehenen Absatz, der entweder nur in dem für eine jeweilige Federklammer 4 vorgesehenen Bereich oder über die gesamte Länge des Halbleitermoduls 2 vorgesehen ist.

Eine jeweilige Federklammer 4 ist so ausgestaltet, dass eine von dieser ausgeübte Kraftwirkung in eine Richtung senkrecht auf die Auflagefläche 1a des Kühlkörpers 1 wirkt. Zur gleichmäßigeren Kraftverteilung können mehr als eine Federklammer 4 mit jeweiligen ersten und zweiten Federklammeraufnahmen 3a und 3d vorgesehen werden, z. B. wie in dem in der Fig. 1 gezeigten Fall zwei Federklammern 4, die jeweils an gegenüberliegenden Rändern der Auflagefläche 1a des Kühlkörpers 1 angeordnet sind. Es ist jedoch auch denkbar, dass mehr als zwei Federklammern 4 vorgesehen werden, z. B. eine an jeder freien Seite des Halbleitermoduls 2, die senkrecht auf der Anlageseite 2a des Halbleitermoduls 2 steht.

Im unteren Teil der Fig. 1 ist in drei Schritten gezeigt, wie der im oberen Teil der Fig. 1 gezeigte montierte Zustand, d. h. ein an einem Kühlkörper 1-befestigte Halbleitermodul 2, erreicht wird. In einem ersten durch die linke Abbildung gezeigten Schritt wird das Halbleitermodul 2 mit seiner Anlageseite 2a an die dafür vorgesehene Auflagefläche 1a des Kühlkörpers 1 angelegt und die Federklammern 4 werden mit einer Seite in die ersten Klammeraufnahmen 3a des Kühlkörpers 1 eingehangen. In diesem Schritt kann auch eine Wärmeleitpaste und/oder -folie zwischen die beiden Kontaktflächen gegeben werden.

In einem zweiten durch die mittlere Abbildung gezeigten Schritt werden die freien Seiten der Federklammern 4 durch mittels Pfeilen angezeigter Einrastvorgänge, d. h. Bewegung zum Halbleitermodul 2 hin, in dessen jeweiligen zweiten Federklammernaufnahmen 3d plaziert. Durch die Federwirkung der beiden Federklammern 4 wird das Halbleitermodul 2 mit dem Kühlkörper 1 verbunden und an diesen angedrückt. Die nach dem Einhängen der Federklammern 4 in die ersten Federklammeraufnahmen 3a des Kühlkörpers 1 freien Seiten der Federklammern 4 sind vorteilhaft so ausgestaltet, dass die Federklammern 4 beim Einrasten in die zweiten Federklammeraufnahmen 3d des Halbleitermoduls 2 noch nicht aufgespreizt, d. h. mit zur Einrastkraft zusätzlichen seitlichen Kräften beaufschlagt, werden müssen.

Die rechte untere Abbildung in der Fig. 1 zeigt den auch in der oberen Abbildung der Fig. 1 gezeigten Endzustand nach der Montage, d. h. nach dem Einrasten der Federklammern 4 am Halbleitermodul 2.

Eine solche Montage ist auch bei einem bereits mit der dem Kühlkörper 1 abgewandten Seite auf eine Leiterplatte montierten Halbleitermodul 2 möglich.

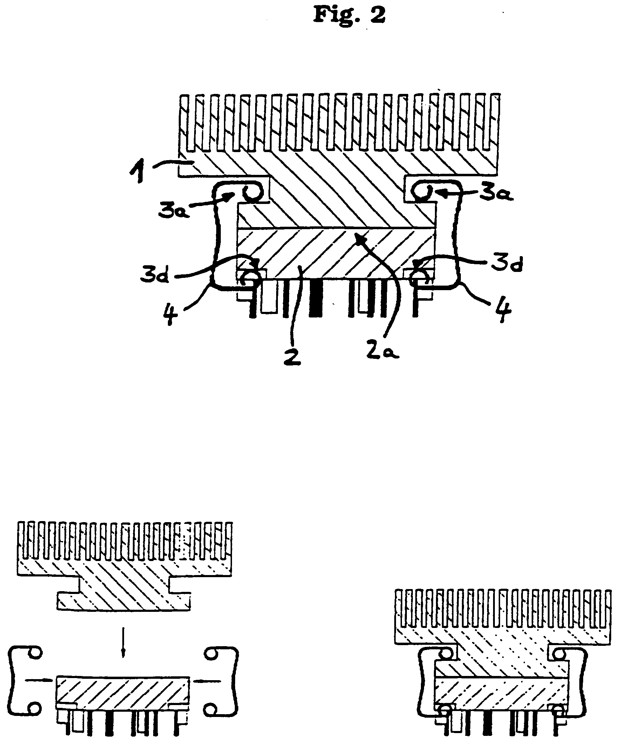

Die Fig. 2 zeigt ein zweites Beispiel. Hier sind für das Halbleitermodul 2 auch in der Fig. 1 nicht gezeigte Anschlussbeine an der der Anlageseite 2a gegenüberliegenden Seite gezeigt. Im Unterschied zu der in der Fig. 1 gezeigten Ausführungsform ist die erste Federklammeraufnahme 3a des Kühlkörpers 1 nicht als die Auflagefläche 1a teilweise unterhöhlende Nut im Kühlkörper 1 vorgesehen, sondern zu den bezüglich der Auflagefläche 1a für das Halbleitermodul 2 senkrecht stehenden Seiten des Kühlkörpers 1 offen, wodurch die Federklammern 4 nicht wie nach der ersten in der Fig. 1 gezeigten Ausführungsform von schräg unten kommend in die erste Federklammeraufnahme 3a eingehängt werden müssen, sondern seitlich aus einer Richtung senkrecht zu der für das Halbleitermodul 2 vorgesehenen Auflagefläche aufgeschoben werden können. Dies hat bei eine antsprechend dem in der Fig. 1 gezeigten ersten Beispiel ausgestalteten zweiten Federklammeraufnahme 3d des Halbleitermoduls 2 den Vorteil einer vereinfachten Montage, wie sie im unteren Teil der Fig. 2 dargestellt ist. Die untere linke Abbildung der Fig. 2 zeigt, dass zunächst in einem ersten Schritt der Kühlkörper 1 mit seiner Auflagefläche 1a auf die Anlageseite 2a des Halbleitermoduls 2 aufgesetzt wird, wonach die beiden Federklammern 4 in einem zweiten Schritt durch seitliches Aufschieben in die jeweiligen ersten und zweiten Federklammeraufnahmen 3a, 3d eingesetzt werden, um den rechts untern gezeigten montierten Zustand zu erhalten, der auch im oberen Teil der Fig. 2 gezeigt ist.

Ebenso wie gemäß dem ersten Beispiel können auch bei dem zweiten Beispiel Wärmeleitpaste und/oder -folie zwischen die beiden Kontaktflächen des Kühlkörpers 1 und des Halbleitermoduls 2 gegeben werden. Auch sind die Federklammern 4 vorteilhaft so ausgestaltet, dass sie beim Aufschieben nicht extra aufgehalten werden müssen.

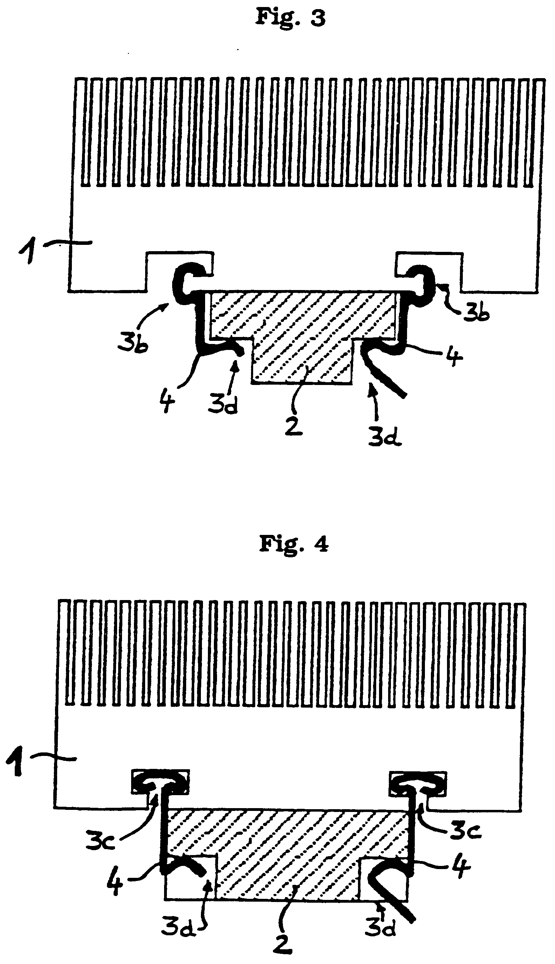

Die Fig. 3 und 4 zeigen zwei weitere Beispiele, bei denen die Verbindung Federklammer und Kühlkörper so erfolgt, dass die Klammer selbsttätig am/im Kühlkörper 1 hält, wodurch eine noch einfachere Handhabung gewährleistet ist.

In dem in der Fig. 3 gezeigten dritten Beispiel ist im Unterschied zu den zuvor beschriebenen Beispiele bei einer ersten Kühlkörperaufnahme 3b des Kühlkörpers 1 ein Kragen über deren gesamte Länge vorgesehen, über eine in dessen Endbereich ausgebildete Verdickung eine Federklammer 4 so eingesetzt werden kann, dass sie selbsttätig am Kühlkörper hält. Die Funktionalität und Befestigung des Halbleitermoduls 2 am Kühlkörper 1 entspricht der ersten Ausführungsform nach der Erfindung, wobei die Federklammern 4 zur Befestigung des Halbleitermoduls entweder zunächst auseinander gebogen werden müssen, um ein Anlegen des Kühlkörpers 1 an das Halbleitermodul 2 zu ermöglichen, wie bei einer in der Fig. 3 links gezeigten Federklammer 4, oder so ausgestaltet sein müssen, dass sie sich beim Aufstecken des Kühlkörpers 1 auf das Halbleitermodul 2 selbsttätig auseinanderbiegen, wie es bei einer in der Fig. 3 rechts gezeigten Federklammer 4 der Fall ist. Nach einem solchen Anlegen können die Federklammern 4 aufgrund ihrer Ausgestaltung entweder durch einfaches Loslassen oder durch automatisches Einschnappen selbsttätig in die zweiten Federklammeraufnahme 3d des Halbleitermoduls 2 einrasten und das Halbleitermodul 2 an dem Kühlkörper 1 halten und an diesen drücken.

Das vierte Beispiel unterscheidet sich zum dritten lediglich dahingehend, dass eine Federklammer 4 nicht an einer kragenförmigen ersten Federklammeraufnahme 3b, sondern an einer nutförmigen ersten Federklammeraufnahme 3c so am Kühlkörper befestigt werden kann, dass sie selbsttätig im Kühlkörper hält. Dazu weist die erste Federklammeraufnahme 3c eine sich im Kühlkörper 1 befindliche Nut auf, die sich in den Kühlkörper 1 hinein z. B. absatzförmig verbreitert, so dass eine entsprechend angepasste Federklammer 4 dort so eingesetzt werden kann, dass sie selbsttätig im Kühlkörper hält. Die Montage des mit wenigstens einer Federklammer 4 bestückten Kühlkörpers 1 an ein Halbleitermodul geschieht entsprechend der in der Fig. 3 gezeigten dritten Ausführungsform nach der Erfindung.

Die zuvor beschriebenen Beispiele können natürlich miteinander kombiniert werden, wobei die verschiedenen Formen von Federklammern 4 bzw. Federklammeraufnahmen 3a, 3b, 3c, 3d beliebig miteinander kombiniert werden können, so dass auch am Halbleitermodul 2 Federklammeraufnahmen 3b oder 3c mit einem Kragen oder einer Nut vorgesehen sein können. Eine Federklammeraufnahme 3a, 3b, 3c, 3d erstreckt sich entweder über eine komplette Seite des Kühlkörpers 1 bzw. des Halbleitermoduls 2 oder über einen Teilbereich davon.

Alternativ kann eine jeweilige Federklammer 4 auch einstückig mit dem Kühlkörper 1 oder dem Halbleitermodul 2 gefertigt sein.

Die zuvor beschriebenen Federklammern beziehen ihre den Kühlkörper 1 und das Halbleitermodul 2 zusammenhaltende Federkraft entweder aus wenigstens einem ihrer in eine jeweilige Federklammeraufnahme einrastenden Endbereich, wie es in den Fig. 1, 3 und 4 gezeigt ist, oder aus dem dazwischen liegenden Mittelbereich, wie es in der Fig. 2 gezeigt ist. Alternativ sind natürlich auch andere Ausführungsformen von Federklammern denkbar.

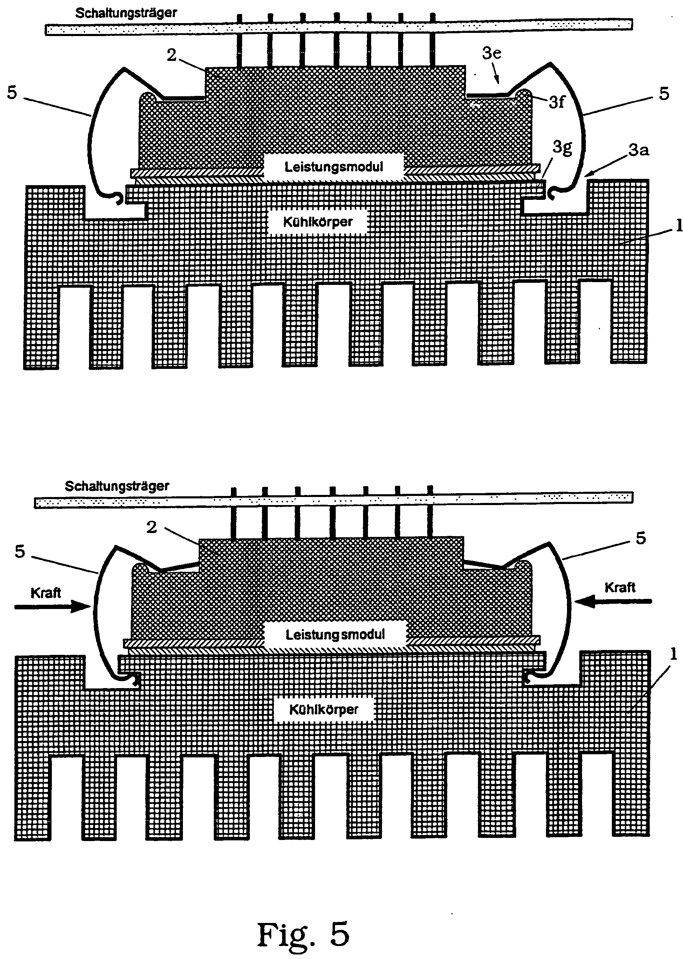

Die Fig. 5 zeigt eine Ausführungsform der Erfindung. Im Unterschied zu dem in der Fig. 1 gezeigten Beispiel ist die zweite Federklammeraufnahme 3d des Halbleitermoduls 2, die stufenförmig ausgebildet ist, als beckenförmige Federklammeraufnahme 3e ausgebildet, welche an der Außenkante des Halbleitermoduls 2 eine Bordkante 3f aufweist. Diese Ausgestaltung hat den Vorteil einer seitlichen Positionierung durch die Wände des Beckens und eines verstärkten Halts einer Federklammer in der Federklammeraufnahme durch die Bordkante 3f sowohl im entspannten Zustand bevor die Federklammer das Halbleitermodul 2 mit dem Kühlkörper 1 verbindet, als auch in diesem gespannten oder montierten Zustand. Der Kühlkörper 1, und hier insbesondere die erste Federklammeraufnahme 3a, entspricht dem ersten.

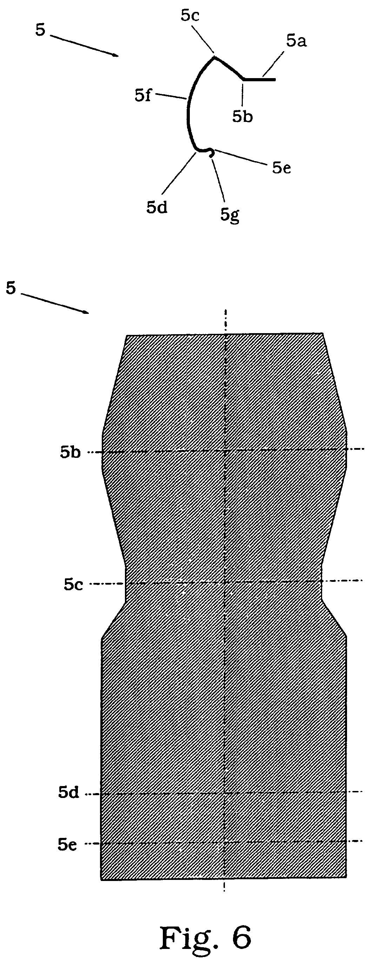

Zusammen mit einer in der Fig. 6 gezeigten erfindungsgemäße Federklammer 5 ergibt sich eine vereinfachte Montage, wie sie in der Fig. 5 dargestellt ist.

Das elastische Ausgangsmaterial der in der Fig. 6 gezeigten Federklammer 5 nach der Erfindung weist prinzipiell eine rechteckige Form auf und wird durch mehrere Formschritte in die besonders ausgestaltete Federklammer 5 mit einer glatten Endfläche 5a, vier Biegekanten 5b - 5e, einem Klammerbogen 5f und einer gebogenen Endfläche 5g gewandelt. Die gerade Endfläche 5a ist in ihrer Größe an eine dafür vorgesehene Auflagefläche der beckenförmigen Federklammeraufnahme 3e angepasst. An die glatte Endfläche 5a schließt sich eine erste Biegekante 5b an, bei der das Ausgangsmaterial der besonders ausgestalteten Federklammer 5 in einem stumpfen Winkel nach oben abgeknickt ist. Der Winkel ist so zu wählen, dass die besonders ausgestaltete Federklammer 5 weder im Montagezustand, d. h. im entspannten Zustand bevor die Federklammer das Halbleitermodul 2 mit dem Kühlkörper 1 verbindet, noch in dem gespannten oder montierten Zustand an der Bordkante 3f der beckenförmigen Federklammeraufnahme anliegt, hier ca. 140° bis 150°. Nach einem in seiner Länge etwa der glatten Endfläche 5a entsprechenden Abschnitt ist das Ausgangsmaterial an einer zweiten Biegekante 5c in einem Winkel von ca. 90° nach unten abgeknickt, um in den in seiner Länge an einen Abstand zwischen der beckenförmigen Federklammeraufnahme 3e des Halbleitermoduls und der stufenförmigen Federklammeraufnahme 3a des Kühlkörpers 1 angepassten Klammerbogen 5f überzugehen. Nach dem Klammerbogen 5f ist das Ausgangsmaterial an einer dritter Biegekante 5c in einem Winkel von ca. 90° nach oben zu der glatten Endfläche 5a hin abgebogen, bevor es mit einer vierten Biegekante 5d mit einer engen Biegung von ca. 180° in einen gebogenen Endbereich 5g endet.

Der im montierten Zustand nach außen gewölbte Klammerbogen 5f bildet zusammen mit dem zwischen der ersten Biegekante 5b und der zweiten Biegekante 5c liegenden Abschnitt, der zweiten Biegekante 5c und der dritten Biegekante 5d einen Spannbogen, der das Halbleitermodul 2 im montierten Zustand an den Kühlkörper 1 spannt.

Die obere Abbildung der Fig. 5 zeigt, dass zunächst in einem ersten Schritt das Halbleitermodul 2 mit einem montierten Schaltungsträger und zwei eingelegten besonders ausgestalteten Federklammern 5 kopfüber, d.h. mit nach oben zeigendem Schaltungsträger, mit seiner Anlageseite 2a auf die Auflagefläche 1a des Kühlkörpers 1 aufgesetzt wird. Im aufgesetzten Zustand steht das gebogene Ende 5g einem Zahn 3g der jeweiligen ersten Federklammeraufnahmen 3a mit einem geringen Abstand gegenüber. Der Abstand dient dazu, ein Berühren der besonders ausgestalteten Federklammern 5 mit der ersten Federklammeraufnahme 3a des Kühlkörpers 1 zu vermeiden, das beim Herabsetzen des Halbleitermoduls 2 auf den Kühlkörper 1 aufgrund möglicher Ungenauigkeiten der Montagevorrichtung erfolgen könnte, damit eine ungewollte Verstellung der Klammer aus ihrer Ausgangsstellung verhindert wird. Die Länge des zwischen der ersten Biegekante 5b und der zweiten Biegekante 5c liegenden Abschnitts der besonders ausgestalteten Federklammer 5 bestimmt sich über den hier benötigten Abstand. Nach dem ersten Montageschritt werden die beiden besonders ausgestalteten Federklammern 5 in einem zweiten Schritt durch aufbringen einer seitlichen Kraft und ein dadurch bedingtes Wippen der besonders ausgestalteten Federklammer 5 um ihre erste Biegekante 5b mit ihrer gebogenen Endfläche 5g über den Zahn 3g in die jeweiligen ersten Federklammeraufnahmen 3a eingerastet, um den in der Fig. 5 unten gezeigten montierten Zustand zu erhalten. Hierbei unterstützt die Bordkante 3f, dass die besonders ausgestaltete Federklammer 5 nicht aus der normalerweise mit einer glatten Oberfläche versehenen beckenförmigen Federklammeraufnahme 3e des Halbleitermoduls 2 herausrutscht.

Die besonders ausgestaltete Federklammer 5 weist aufgrund ihrer Form die Funktionalität auf, dass sie beim Aufbringen der Kraft um die erste Biegekante 5b wippt. Weiter entsteht um die zweite Biegekante 5c und dritte Biegekante 5d mit dazwischenliegendem Klammerbogen 5f ein Spannbogen und an der vierten Biegekante 5e zusammen mit dem gebogenen Endstück 5g erfolgt das Aufspannen.

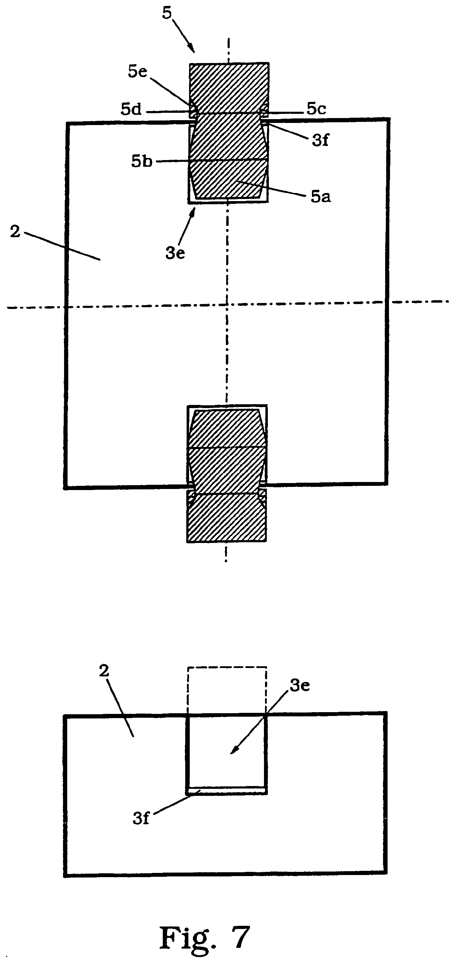

Da die besonders ausgestaltete Federklammer 5 in der Regel in eine beckenförmige Federklammeraufnahme 3e des Halbleitermoduls 2 gesetzt wird, wie es auch in der oberen Hälfte der Fig. 7 in einer Aufsicht gezeigt ist, wobei die beckenförmige Federklammeraufnahme 3e Wände aufweist, die auch über den Körper des Halbleitermoduls 2 hinausgehen können, wie es durch gestrichelte Linien in der unteren Hälfte der Fig. 7 gezeigt ist, ist die besonders ausgestaltete Federklammer 5 vorzugsweise um die erste Biegekante 5b und die zweite Biegekante 5c herum schmaler ausgeführt. Dadurch erhält sie einen festen Halt zwischen den Wänden und kann bei der seitlichen Krafteinwirkung um die erste Biegekante 5b herum wippen und an dieser die Spannkraft aufnehmen.

Der Klammerbogen 5f kann natürlich auch eine im montierten Zustand nach innen gewölbte oder eine glatte Form aufweisen, wobei die Knick- bzw. Biegewinkel an den Biegekanten entsprechend angepasst werden müssen.

Ebenso wie gemäß des ersten Beispiels können auch bei der Erfindung Wärmeleitpaste und/oder -folie zwischen die beiden Kontaktflächen des Kühlkörpers 1 und des Halbleitermoduls 2 gegeben werden.

### Bezugszeichenliste

- 1: Kühlkörper
- 1a: Auflagefläche des Kühlkörpers 1 für das Halbleitermodul 2
- 2: Halbleitermodul
- 2a: Anlageseite des Halbleitermoduls 2 am Kühlkörper 1
- 3a: stufenförmige Federklammeraufnahme des Kühlkörpers 1
- 3b: kragenförmige Federklammeraufnahme des Kühlkörpers 1
- 3c: nutförmige Federklammeraufnahme des Kühlkörpers 1
- 3d: stufenförmige Federklammeraufnahme des Halbleitermoduls 2
- 3e: beckenförmige Federklammeraufnahme mit Bordkante 3f des Halbleitermoduls 2
- 3f: Bordkante der beckenförmigen Federklammeraufnahme 3e des Halbleitermoduls 2
- 3g: Zahn der stufenförmigen Federklammeraufnahme 3a des Kühlkörpers 1
- 4: Federklammer
- 5: Besondere Ausführungsform einer Federklammer
- 5a: glatte Endfläche der besonders ausgeführten Federklammer 5
- 5b: erste Biegekante der besonders ausgeführten Federklammer 5
- 5c: zweite Biegekante der besonders ausgeführten Federklammer 5
- 5d: dritte Biegekante der besonders ausgeführten Federklammer 5
- 5e: vierte Biegekante der besonders ausgeführten Federklammer 5
- 5f: Klammerbogen der besonders ausgeführten Federklammer 5
- 5g: gebogene Endfläche der besonders ausgeführten Federklammer 5

## Patentansprüche

1. Vorrichtung, umfassend ein Halbleitermodul (2), einen Kühlkörper (1) und eine Federklammer (5) mit einer gebogenen Endfläche,
wobei das Halbleitermodul (2), wenigstens eine erste Federklammeraufnahme (3e) zur jeweiligen Aufnahme einer Federklammer (5), die das Halbleitermodul (2) an dem Kühlkörper (1) hält, aufweist und wobei
die erste Federklammeraufnahme (3e) eine Bordkante (3f) an der Außenseite des Halbleitermoduls (2) aufweist, durch die ein Ende der Federklammer (5) zumindest im gespannten Zustand gehalten wird, in dem das Halbleitermodul (2) mittels der Federklammer (5) mit dem Kühlkörper (1) verbunden ist, **dadurch gekennzeichnet, dass** die Federklammer (5) eine glatte Endfläche (5a), vier Biegekanten (5b, 5c, 5d, 5e) und einen Klammerbogen (5f) aufweist (2) wobei die glatte Endfläche (5a) in ihrer Größe an die Federklammeraufnahme (3e) angepasst ist,

2. Vorrichtung nach Anspruch 1,
**dadurch gekennzeichnet,**
**dass** an dem Kühlkörper (1) zwei zweite Federklammeraufnahmen (3a) vorgesehen sind.

3. Vorrichtung nach Anspruch 2,
**dadurch gekennzeichnet, dass** die Federklammer (5) aufweist:
- wenigstens einen an die jeweilige erste Federklammeraufnahme (3e) des Halbleitermoduls (2) und/oder zweite Federklammeraufnahme (3a) des Kühlkörpers (1) angepassten Abschnitt zum Einrasten in der ersten und/oder zweiten Federklammeraufnahme (3e; 3a) zumindest im gespannten Zustand, in dem das Halbleitermodul (2) mittels der Federklammer (5) mit dem Kühlkörper (1) verbunden ist, und
- eine so an die erste Federklammeraufnahme (3e) angepasste glatte Endfläche (5a), dass die in die erste Federklammeraufnahme (3e) eingesetzte Federklammer (5) frei an dem Halbleitermodul hängt und an dem Herausfallen gehindert wird.

4. Vorrichtung nach Anspruch 3,
**gekennzeichnet durch**
eine erste Biegekante (5b), um die die Federklammer (5) bei einem Einrastvorgang wippt, sowie eine zweite Biegekante (5c) und eine dritte Biegekante, zwischen denen ein Spannbogen gebildet wird, mittels dem die erwünschte Anpresskraft des Halbleitermoduls (2) an den Kühlkörper (1) eingestellt wird.

## Claims

1. Device, comprising a semiconductor module (2), a heat sink (1) and a spring clip (5) having a bent end face,
wherein the semiconductor module (2) has at least one first spring clip receptacle (3e) for respectively receiving a spring clip (5) which holds the semiconductor module (2) on the heat sink (1), and wherein
the first spring clip receptacle (3e) has a flange edge (3f) on the outer side of the semi-conductor module (2), by means of which one end of the spring clip (5) is held at least in the tensioned state in which the semiconductor module (2) is connected to the heat sink (1) by means of the spring clip (5),
**characterized in that**
the spring clip (5) has a smooth end face (5a), four bending edges (5b, 5c, 5d, 5e) and a clip arc (5f), wherein the smooth end face (5a) is adapted in its size to the spring clip receptacle (3e).

2. Device according to Claim 1,
**characterized**
**in that** two second spring clip receptacles (3a) are provided on the heat sink (1).

3. Device according to Claim 2,
**characterized in that**
the spring clip (5) has:
- at least one section which is adapted to the respective first spring clip receptacle (3e) of the semiconductor module (2) and/or second spring clip receptacle (3a) of the heat sink (1), for latching in the first and/or second spring clip receptacle (3e; 3a) at least in the tensioned state in which the semiconductor module (2) is connected to the heat sink (1) by means of the spring clip (5), and
- a smooth end face (5a) adapted to the first spring clip receptacle (3e) such that the spring clip (5) inserted into the first spring clip receptacle (3e) is freely suspended from the semiconductor module and prevented from falling out.

4. Device according to Claim 3,
**characterized by**
a first bending edge (5b), about which the spring clip (5) rocks during a latching operation, and also a second bending edge (5c) and a third bending edge, between which a tensioning arc is formed by means of which the desired press-on force of the semiconductor module (2) onto the heat sink (1) is set.

## Revendications

1. Dispositif comprenant un module à semi-conducteurs (2), un corps de refroidissement (1) et une pince élastique (5) avec une surface d'extrémité courbe, le module à semi-conducteurs (2) présentant au moins un premier logement de pince élastique (3e) pour recevoir à chaque fois une pince élastique (5) qui retient le module à semi-conducteurs (2) sur le corps de refroidissement (1), et
le premier logement de pince élastique (3e) présentant une arête de bord (3f) au niveau du côté extérieur du module à semi-conducteurs (2), laquelle retient une extrémité de la pince élastique (5) au moins dans l'état serré dans lequel le module à semi-conducteurs (2) est connecté au corps de refroidissement (1) au moyen de la pince élastique (5),
**caractérisé en ce que**
la pince élastique (5) présente une surface d'extrémité lisse (5a), quatre arêtes de flexion (5b, 5c, 5d, 5e) et une partie courbe de pince (5f), la surface d'extrémité lisse (5a) ayant une dimension adaptée au logement de pince élastique (3e) .

2. Dispositif selon la revendication 1,
**caractérisé en ce que**
deux deuxièmes logements de pince élastique (3a) sont prévus au niveau du corps de refroidissement (1) .

3. Dispositif selon la revendication 2,
**caractérisé en ce que**
la pince élastique (5) présente :
- au moins une portion adaptée au premier logement de pince élastique respectif (3e) du module à semi-conducteurs (2) et/ou au deuxième logement de pince élastique respectif (3a) du corps de refroidissement (1) pour l'encliquetage dans le premier et/ou le deuxième logement de pince élastique (3e ; 3a) au moins dans l'état serré, dans lequel le module à semi-conducteurs (2) est connecté au moyen de la pince élastique (5) au corps de refroidissement (1), et
- une surface d'extrémité lisse (5a) adaptée au premier logement de pince élastique (3e) de telle sorte que la pince élastique (5) insérée dans le premier logement de pince élastique (3e) soit suspendue librement au module à semi-conducteurs et ne puisse pas tomber de celui-ci.

4. Dispositif selon la revendication 3,
**caractérisé par**
une première arête de flexion (5b), autour de laquelle bascule la pince élastique (5) lors d'une opération d'encliquetage, ainsi qu'une deuxième arête de flexion (5c) et une troisième arête de flexion entre lesquelles est formée une partie courbe de serrage au moyen de laquelle la force de pressage souhaitée du module à semi-conducteurs (2) contre le corps de refroidissement (1) peut être ajustée.
